(19) Europäisches Patentamt
European Patent Office
Office européen des brevets

(11) **EP 4 564 732 A1**

(12) **EUROPEAN PATENT APPLICATION**
published in accordance with Art. 153(4) EPC

(43) Date of publication:
**04.06.2025 Bulletin 2025/23**

(21) Application number: **22956967.8**

(22) Date of filing: **01.09.2022**

(51) International Patent Classification (IPC):
*H04L 7/00* (2006.01)     *H04L 7/033* (2006.01)
*H04L 27/00* (2006.01)     *H04J 3/06* (2006.01)

(52) Cooperative Patent Classification (CPC):
H04J 3/06; H04L 7/00; H04L 7/033; H04L 27/00

(86) International application number:
**PCT/CN2022/116603**

(87) International publication number:
**WO 2024/045142 (07.03.2024 Gazette 2024/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Shenzhen, Guangdong 518129 (CN)**

(72) Inventors:
• **LIU, Qiao**
**Shenzhen, Guangdong 518129 (CN)**

• **CAI, Hua**
**Shenzhen, Guangdong 518129 (CN)**
• **WANG, Guangjian**
**Shenzhen, Guangdong 518129 (CN)**
• **LIU, Yao**
**Shenzhen, Guangdong 518129 (CN)**

(74) Representative: **Körber, Martin Hans**
**Mitscherlich PartmbB**
**Patent- und Rechtsanwälte**
**Karlstraße 7**
**80333 München (DE)**

(54) **COMMUNICATION APPARATUS AND SIGNAL SAMPLING METHOD**

(57)     A communication apparatus and a signal sampling method are provided. The communication apparatus includes a clock control circuit, a data sampling circuit, and a clock recovery circuit. The clock control circuit is configured to determine a sampling clock deviation of the data sampling circuit, and generate a first clock control signal based on the sampling clock deviation, where the first clock control signal is used to adjust a sampling clock of the data sampling circuit. The clock recovery circuit is configured to adjust the sampling clock of the data sampling circuit based on the first clock control signal, and send a clock signal to the data sampling circuit. The data sampling circuit is configured to sample an input analog signal based on the clock signal. By using the communication apparatus, the sampling clock of the data sampling circuit can be locked at an optimal sampling moment, so that a digital signal obtained through sampling can retain wanted information in a raw analog signal without oversampling the raw analog signal, and complexity of the data sampling circuit is not increased even in a high-bandwidth scenario.

FIG. 2

## Description

TECHNICAL FIELD

This application relates to the field of clock synchronization technologies, and specifically, to a communication apparatus and a signal sampling method.

BACKGROUND

In digital communication, an analog signal needs to be converted into a digital signal by using an analog-to-digital converter (analog-to-digital converter, ADC). To enable the digital signal to retain all information in the raw analog signal, theoretically, a sampling frequency of the ADC needs to be greater than or equal to twice of bandwidth occupied by the raw analog signal, and then sampling clock recovery is performed in digital domain to determine an optimal sampling moment. Due to a channel transmission delay and a clock deviation between a transmit end and a receive end, the ADC cannot perform sampling at the optimal sampling moment, resulting in a deviation between captured data and raw data. Therefore, clock synchronization needs to be performed.

Currently, common clock synchronization methods include a Gardner algorithm, an overhead-assisted synchronization method, and the like. The Gardner algorithm is essentially to perform interpolation on a sampled raw sequence, to extend the raw sequence in time domain. During sampling clock recovery, extraction (also referred to as downsampling) is performed on a raw sequence obtained through interpolation, to determine an optimal sampling moment. However, the Gardner algorithm requires oversampling, and therefore is limited in a high-bandwidth scenario. In the overhead-assisted synchronization method, a low-speed overhead signal is inserted into a data signal, and narrowband filtering is performed at a receive for sampling clock recovery. However, the overhead-assisted synchronization method causes additional spectrum overheads, and requires low bandwidth of a filter at the receive end. This leads to high difficulty in designing a filter in a high-bandwidth system.

Therefore, how to implement clock synchronization in a high-bandwidth scenario is a problem that urgently needs to be resolved.

SUMMARY

This application provides a communication apparatus and a signal sampling method, to implement sampling clock synchronization.

**According to a first aspect,** an embodiment of this application provides a communication apparatus. The communication apparatus may be used in a receiver, and the communication apparatus includes a clock control circuit, a data sampling circuit, and a clock recovery circuit. The clock control circuit is configured to determine a sampling clock deviation of the data sampling circuit, and generate a first clock control signal based on the sampling clock deviation, where the first clock control signal is used to adjust a sampling clock of the data sampling circuit. The clock recovery circuit is configured to adjust the sampling clock of the data sampling circuit based on the first clock control signal, and send a clock signal to the data sampling circuit. The data sampling circuit is configured to sample an input analog signal based on the clock signal.

The data sampling circuit is, for example, an ADC module. In this embodiment of this application, the clock control circuit may generate the corresponding first clock control signal based on the sampling clock deviation of the data sampling circuit, and feed back the first clock control signal to the clock recovery circuit. The clock recovery circuit may adjust the sampling clock of the data sampling circuit based on the first clock control signal, and feed back, to the data sampling circuit, a clock signal obtained by an adjusted sampling clock, so that the data sampling circuit performs sampling based on the adjusted sampling clock. The data sampling circuit may feed back, to the clock control circuit again, a signal obtained through sampling based on the adjusted sampling clock. The clock control circuit re-determines a sampling clock deviation of the data sampling circuit, generates a corresponding clock control signal, and feeds back the clock control signal to the clock recovery circuit. The clock recovery circuit may adjust the sampling clock of the data sampling circuit again based on the received clock control signal, and feed back, to the data sampling circuit, a clock signal obtained by an adjusted sampling clock. Because the clock control circuit and the clock recovery circuit may cooperate to adjust the sampling clock of the data sampling circuit for a plurality of times, the sampling clock of the data sampling circuit can be locked at an optimal sampling moment. In this way, a digital signal obtained through sampling can retain wanted information of a raw analog signal without oversampling on the raw analog signal. Because the raw analog signal does not need to be oversampled, complexity of the ADC or complexity of a filter in the receiver is not increased even in a high-bandwidth scenario.

In a possible design, when the first clock control signal indicates that the sampling clock deviation of the data sampling circuit is less than a first threshold, the clock signal is a target clock signal, and the target clock signal is capable of generating a sampling clock expected by the data sampling circuit. The sampling clock expected by the data sampling circuit may be considered as an optimal sampling clock of the data sampling circuit. Through a plurality of times of adjustment by the clock recovery circuit, an actual sampling clock of the data sampling circuit and the optimal sampling clock gradually decrease, until the actual sampling clock of the data sampling circuit is close to or even equal to the optimal sampling clock. In this case, a clock signal generated by the clock recovery circuit is referred to as the target clock signal, to be specific, a clock signal that can enable the data sampling circuit to achieve the optimal sampling clock.

In a possible design, the clock recovery circuit includes a signal splitter, a first delayer, a second delayer, and a multiplication circuit. The signal splitter is connected to an input end of the first delayer and an input end of the second delayer. The multiplication circuit is connected to an output end of the first delayer and an output end of the second delayer. The output end of the first delayer and the output end of the second delayer are further connected to an input end of the clock control circuit. The signal splitter is configured to split an input analog signal into a first analog sub-signal and a second analog sub-signal. The first delayer is configured to delay the first analog sub-signal based on the first clock control signal to obtain a first delayed signal, and output the first delayed signal to the multiplication circuit and the clock control circuit. The second delayer is configured to delay the second analog sub-signal based on the first clock control signal to obtain a second delayed signal, and output the second delayed signal to the multiplication circuit and the clock control circuit. The multiplication circuit is configured to multiply the first delayed signal by the second delayed signal to obtain a first signal, and output the first signal to the data sampling circuit.

In this embodiment of this application, the analog signal input to the clock recovery circuit is the same as the analog signal input to the data sampling circuit. Therefore, the clock recovery circuit adjusts the sampling clock of the data sampling circuit by processing the input analog signal. For example, the clock recovery circuit splits the input analog signal into two signals, and controls delay duration of the two signals to adjust the sampling clock of the data sampling circuit, to enable the sampling clock of the data sampling circuit to reach the optimal sampling clock.

In a possible design, the clock control circuit includes a processor and a decider. The processor may be configured to determine the sampling clock deviation based on a first digital signal and a second digital signal that are output by the data sampling circuit, and generate the first clock control signal based on the sampling clock deviation, where the first digital signal is a real component obtained by the data sampling circuit by sampling the input analog signal, and the second digital signal is an imaginary component obtained by the data sampling circuit by sampling the analog signal. The decider may be configured to determine, based on the first delayed signal and the second delayed signal, that the clock recovery circuit is incapable of generating the target clock signal, and output a second clock control signal to the clock recovery circuit.

In this embodiment of this application, with the clock recovery circuit, the sampling clock deviation of the data sampling circuit can be gradually reduced, until the sampling clock of the data sampling circuit reaches the optimal sampling clock; otherwise, the sampling clock of the data sampling circuit further needs to be adjusted by using the clock recovery circuit. Therefore, if the clock control circuit determines that a clock signal generated by the clock recovery circuit is not the target clock signal, the clock control circuit continues to output a clock control signal to the clock recovery circuit.

In a possible design, the decider is further configured to determine, based on the first delayed signal and the second delayed signal, that the clock recovery circuit is capable of generating the target clock signal, and output an indication signal to the clock recovery circuit. The indication information indicates that the sampling clock of the data sampling circuit does not need to be adjusted. When determining that a clock signal generated by the clock recovery circuit is the target clock signal, the clock control circuit outputs the indication signal to the clock recovery circuit, to indicate the clock recovery circuit not to continue to adjust the sampling clock of the data sampling circuit.

In a possible design, the decider is specifically configured to: determine, based on the first delayed signal, first duration by which the first analog sub-signal is delayed; determine, based on the second delayed signal, second duration by which the second analog sub-signal is delayed; and when a deviation between the sampling clock expected by the data sampling circuit and a difference between the first duration and the second duration is greater than the first threshold, determine that the clock recovery circuit is incapable of generating the target clock signal.

In a possible design, that the first delayer delays the first analog sub-signal based on the first clock control signal includes: the first delayer delays the first analog sub-signal based on a first delay step when the first clock control signal indicates that the sampling clock deviation is greater than or equal to a first value, or the first delayer delays the first analog sub-signal based on a second delay step when the first clock control signal indicates that the sampling clock deviation is less than the first value, where the first delay step is greater than the second delay step; and that the second delayer delays the second analog sub-signal based on the first clock control signal includes: the second delayer delays the second analog sub-signal based on a third delay step when the first clock control signal indicates that the sampling clock deviation is greater than or equal to a first value, or the second delayer delays the second analog sub-signal based on a fourth delay step when the first clock control signal indicates that the sampling clock deviation is less than the first value, where the third delay step is greater than the fourth delay step.

In this embodiment of this application, a plurality of delay steps may be separately predefined for the first delayer and the second delayer. When the data sampling clock deviation is large, the first delayer and the second delayer correspondingly delay the input analog signal based on a large delay step; or when the data sampling clock deviation is small, the first delayer and the second delayer correspondingly delay the input analog signal based on a small delay step, to improve efficiency and precision of sampling clock adjustment.

In a possible design, the clock recovery circuit further includes a first low-pass filter, connected to the multiplication circuit and configured to filter out a high-frequency component from the first signal, to reduce interference caused by the high-frequency component.

In a possible design, the clock recovery circuit further includes an amplitude limiting amplifier, connected to the first low-pass filter and configured to filter out a component whose amplitude is greater than a first amplitude from a signal output by the first low-pass filter, to reduce a probability of signal saturation.

In a possible design, the clock recovery circuit further includes a phase-locked loop, connected to the amplitude limiting amplifier and configured to enable a frequency of the target clock signal to be consistent with a frequency of the first signal, to improve phase stability.

In a possible design, the communication apparatus further includes a phase locking module. The phase locking module is separately connected to the clock control circuit and the data sampling circuit. The phase locking circuit is configured to determine a sampling phase deviation of the data sampling circuit based on an error signal, generate a third control signal based on the sampling phase deviation, and output the third control signal to the data sampling circuit. The error signal is an error signal between the first digital signal and the second digital signal that are output by the data sampling circuit. The third control signal indicates the data sampling circuit to adjust a sampling phase.

In this embodiment of this application, in view of a phase deviation of the sampling clock, the phase locking circuit is disposed. The clock control circuit calculates the phase deviation of the sampling clock of the data sampling circuit, and feeds back the phase deviation to the phase locking circuit. The phase locking circuit feeds back the phase deviation to the data sampling circuit for adjusting a phase of the sampling clock.

In a possible design, the phase locking module includes a phase detector, a voltage-controlled oscillator, and a second low-pass filter that are sequentially connected to the clock control circuit. An input end of the second low-pass filter is connected to the voltage-controlled oscillator, and an output end of the second low-pass filter is connected to the data sampling circuit.

According to a second aspect, an embodiment of this application provides a signal sampling method. The method may be performed by a communication apparatus. The communication apparatus includes a clock control circuit, a data sampling circuit, and a clock recovery circuit. The clock control circuit determines a sampling clock deviation of the data sampling circuit, and generates a first clock control signal based on the sampling clock deviation, where the first clock control signal is used to adjust a sampling clock of the data sampling circuit. The clock recovery circuit adjusts the sampling clock of the data sampling circuit based on the first clock control signal, and sends a clock signal to the data sampling circuit. The data sampling circuit samples an input analog signal based on the clock signal.

In a possible implementation, the first clock control signal indicates that the sampling clock deviation of the data sampling circuit is less than a first threshold, the clock signal is a target clock signal, and the target clock signal is capable of generating a sampling clock expected by the data sampling circuit.

In a possible implementation, the clock recovery circuit includes a signal splitter, a first delayer, a second delayer, and a multiplication circuit. The first delayer is connected to the signal splitter and the clock control circuit, and the second delayer is connected to the signal splitter and the clock control circuit. The signal splitter splits an input analog signal into a first analog sub-signal and a second analog sub-signal. The first delayer delays the first analog sub-signal based on the first clock control signal to obtain a first delayed signal, and outputs the first delayed signal to the multiplication circuit and the clock control circuit. The second delayer delays the second analog sub-signal based on the first clock control signal to obtain a second delayed signal, and outputs the second delayed signal to the multiplication circuit and the clock control circuit. The multiplication circuit multiplies the first delayed signal by the second delayed signal to obtain a first signal, and outputs the first signal to the data sampling circuit.

In a possible implementation, the clock control circuit includes a processor and a delayer. The processor determines the sampling clock deviation based on a first digital signal and a second digital signal that are output by the data sampling circuit, and generates the first clock control signal based on the sampling clock deviation, where the first digital signal is a real component obtained by the data sampling circuit by sampling the input analog signal, and the second digital signal is an imaginary component obtained by the data sampling circuit by sampling the input analog signal. The decider determines, based on the first delayed signal and the second delayed signal, that the clock recovery circuit is incapable of generating the target clock signal, and outputs a second clock control signal to the clock recovery circuit.

In a possible implementation, the decider further determines, based on the first delayed signal and the second delayed signal, that the clock recovery circuit is capable of generating the target clock signal, and outputs an indication signal to the clock recovery circuit. The indication information indicates that the sampling clock of the data sampling circuit does not need to be adjusted.

In a possible implementation, the decider is specifically configured to: determine, based on the first delayed signal, first duration by which the first analog sub-signal is delayed; determine, based on the second delayed signal, second duration by which the second analog sub-signal is delayed; and when a deviation between the sampling clock expected by the data sampling circuit and a difference between the first duration and the second duration is greater than the first threshold, determine that the clock recovery circuit is incapable of generating the target clock signal.

In a possible implementation, the first delayer delays the first analog sub-signal based on a first delay step when the first clock control signal indicates that the sampling clock deviation is greater than or equal to a first value, or the first delayer delays the first analog sub-signal based on a second delay step when the first clock control signal indicates that the sampling clock deviation is less than the first value, where the first delay step is greater than the second delay step; and the second delayer delays the second analog sub-signal based on a third delay step when the first clock control signal indicates that the sampling clock deviation is greater than or equal to a first value, or the second delayer delays the second analog sub-signal based on a fourth delay step when the first clock control signal indicates that the sampling clock deviation is less than the first value, where the third delay step is greater than the fourth delay step.

In a possible implementation, the clock recovery circuit further includes a first low-pass filter connected to the multiplication circuit, and the first low-pass filter is configured to filter out a high-frequency component from the first signal.

In a possible implementation, the clock recovery circuit further includes an amplitude limiting amplifier connected to the first low-pass filter, and the amplitude limiting amplifier is configured to filter out a component whose amplitude is greater than a first amplitude from a signal output by the first low-pass filter.

In a possible implementation, the clock recovery circuit further includes a phase-locked loop connected to the amplitude limiting amplifier, and the phase-locked loop is configured to enable a frequency of the target clock signal to be consistent with a frequency of the first signal.

In a possible implementation, the communication apparatus further includes a phase locking module, the phase locking module is separately connected to the clock control circuit and the data sampling circuit, and the method further includes: The phase locking circuit determines a sampling phase deviation of the data sampling circuit based on an error signal, generates a third control signal based on the sampling phase deviation, and outputs the third control signal to the data sampling circuit. The error signal is an error signal between the first digital signal and the second digital signal that are output by the data sampling circuit. The third control signal indicates the data sampling circuit to adjust a sampling phase.

In a possible implementation, the phase locking module includes a phase detector, a voltage-controlled oscillator, and a second low-pass filter that are sequentially connected to the clock control circuit. An input end of the second low-pass filter is connected to the voltage-controlled oscillator, and an output end of the second low-pass filter is connected to the data sampling circuit.

According to a third aspect, an embodiment of this application provides a receiver. The receiver includes the communication apparatus according to any one of the first aspect or the possible implementations of the first aspect.

According to a fourth aspect, an embodiment of this application provides a receiver. The receiver includes an input/output interface and a logic circuit. The input/output interface is configured to input and/or output information. The logic circuit is configured to perform the method according to the second aspect.

According to a fifth aspect, an embodiment of this application provides a chip system. The chip system includes a communication interface and a processor, so that a device on which a system chip is installed performs the method according to any one of the second aspect or the possible implementations of the second aspect. In a possible implementation, the chip system further includes the memory, configured to store a computer program. The chip system may include a chip, or may include a chip and another discrete component.

According to a sixth aspect, this application provides a computer-readable storage medium. The computer-readable storage medium stores a computer program. When the computer program is run, the method according to any one of the second aspect or the possible implementations of the second aspect is implemented.

According to a seventh aspect, a computer program product is provided. The computer program product includes computer program code. When the computer program code is run, the method according to any one of the second aspect or the possible implementations of the second aspect is performed.

For benefits of the second aspect to the seventh aspect and the implementations thereof, refer to the descriptions of the benefits of the first aspect and the possible designs thereof.

BRIEF DESCRIPTION OF DRAWINGS

FIG. 1 is a diagram of an architecture of a communication system to which embodiments of this application are applicable;
FIG. 2 is a diagram of a structure of a communication apparatus according to an embodiment of this application;
FIG. 3 is a diagram of a condition that an optimal sampling clock of a data sampling circuit needs to meet according to an embodiment of this application;
FIG. 4 is a diagram of another structure of a communication apparatus according to an embodiment of this application;
FIG. 5 is a diagram of still another structure of a communication apparatus according to an embodiment of this application; and

FIG. 6 is a diagram of a deviation between an actual sampling clock of a data sampling circuit and an expected sampling clock according to an embodiment of this application.

DESCRIPTION OF EMBODIMENTS

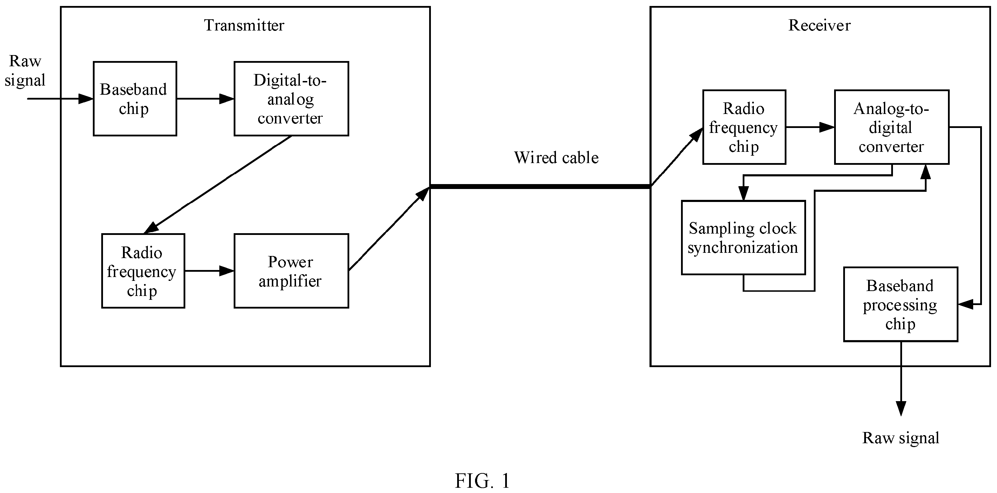

Technical solutions provided in embodiments of this application may be applied to a device that needs to perform ADC, for example, a receiver. The receiver may communicate with a transmitter through a wireless channel or a wired cable. In an example, FIG. 1 is a diagram of a network architecture of a communication system to which embodiments of this application are applicable. The communication system may include a transmitter and a receiver. In FIG. 1, for example, the transmitter and the receiver communicate with each other through a wired cable. The transmitter includes a baseband chip, a digital-to-analog converter (digital-to-analog converter, DAC), a radio frequency chip, and a power amplifier. The base station chip is configured to process a to-be-sent signal, and send a digital signal obtained through processing to the DAC for digital-to-analog conversion, to be specific, for converting the digital signal into an analog signal. The radio frequency chip converts the analog signal into a radio frequency signal. Then the radio frequency signal passes through the power amplifier and is transmitted to a radio frequency chip in the receiver through a wireless channel or a wired cable. The radio frequency chip in the receiver performs down-conversion on received radio frequency information. Then an ADC converts radio frequency information obtained through down-conversion into a digital signal. The digital signal may be used to restore information carried in a signal sent by the transmitter. A baseband processing chip in the receiver may process the digital signal to obtain raw information sent by the transmitter. It should be noted that components included in the transmitter and the receiver in FIG. 1 are merely examples, and the transmitter and the receiver may further include other possible components, such as a filter and a frequency mixer. The components are not listed one by one herein.

To enable a digital signal to retain all information in an analog signal sent by the transmitter, theoretically, a sampling frequency of the ADC needs to be greater than or equal to twice of bandwidth occupied by the raw analog signal. In view of impact of some factors, an accurate sampling frequency cannot be ensured, and the ADC even usually needs to perform sampling at a higher sampling frequency (also referred to as oversampling). The ADC performs oversampling, and correspondingly, sampling clock recovery needs to be performed in digital domain to determine an optimal sampling moment. Due to a channel transmission delay and a clock deviation between a transmit end and a receive end, the ADC cannot perform sampling at the optimal sampling moment, and consequently, there is a deviation between captured data and raw data. Therefore, clock synchronization needs to be performed, as shown in FIG. 1. Sampling clock synchronization can enable the ADC to perform sampling at the optimal sampling moment.

Currently, common clock synchronization methods include a Gardner algorithm, an overhead-assisted synchronization method, and the like. The Gardner algorithm essentially performs interpolation on a sampled raw sequence, so that the raw sequence is extended in time domain. During sampling clock recovery, extraction (also referred to as downsampling) is performed on a raw sequence obtained through interpolation, to determine an optimal sampling moment. However, oversampling needs to be performed in the Gardner algorithm, and therefore application of the Gardner algorithm in a high-bandwidth scenario is limited. In the overhead-assisted synchronization method, a low-speed overhead signal is inserted into a data signal, and narrowband filtering is performed at a receive end to recover a sampling clock. However, the overhead-assisted synchronization method causes additional spectrum overheads, and bandwidth of a filter at the receive end needs to be low. This leads to high difficulty in designing a filter in a high-bandwidth system.

In embodiments of this application, a sampling clock of the ADC can be locked at an expected sampling clock (an optimal sampling clock). Because the ADC is locked to operate at the optimal sampling clock, a digital signal obtained through sampling can retain wanted information of a raw analog signal without oversampling on the raw analog signal. The ADC does not need to oversample the raw analog signal. To be specific, a sampling frequency of the ADC is irrelevant to a value of bandwidth of the raw analog signal. Therefore, in the solutions provided in embodiments of this application, complexity of the ADC or complexity of a filter in the receiver is not increased even in a high-bandwidth scenario.

The technical solutions provided in embodiments of this application are described below with reference to the accompanying drawings. In embodiments of this application, a high frequency and a low frequency are defined relative to each other. For example, a frequency range of the high frequency may be [$1.5\times$Fs, $+\infty$], and a frequency range of the low frequency may be [0, $1.5\times$Fs], where Fs is bandwidth of a first signal. A delayer is also referred to as a retarder.

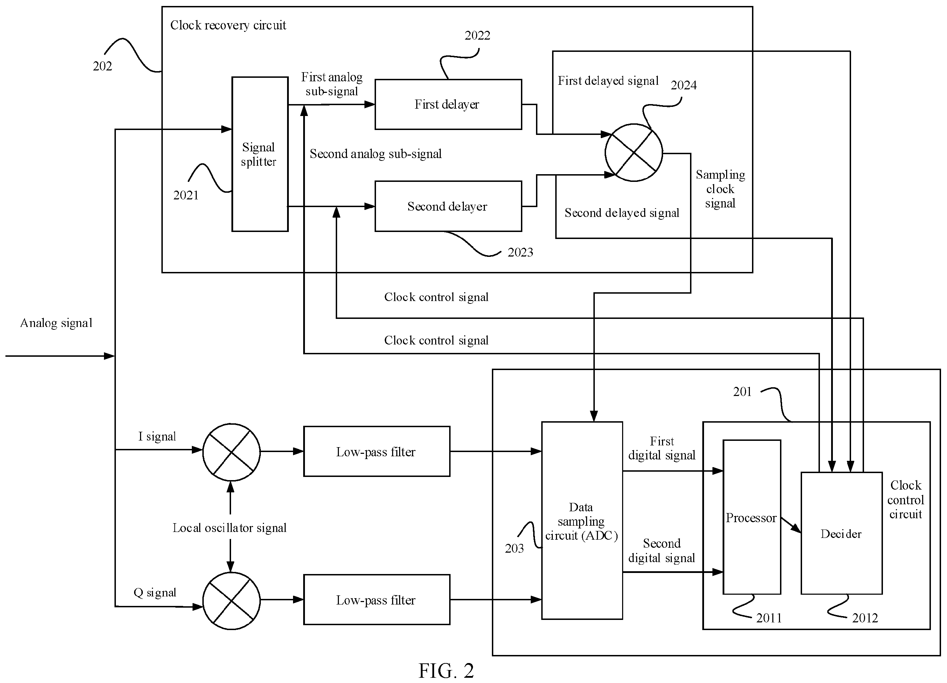

FIG. 2 is a diagram of a structure of a communication apparatus according to an embodiment of this application. The communication apparatus may be used in a receiver. As shown in FIG. 2, the communication apparatus includes a clock control circuit 201, a clock recovery circuit 202, and a data sampling circuit 203. The clock control circuit 201 is separately connected to the data sampling circuit 203 and the clock recovery circuit. The clock recovery circuit 202 is further connected to the data sampling circuit 203. The data sampling circuit 203 is, for example, an ADC module. It should be noted that the clock control circuit 201 and the clock recovery circuit 202 may be two independent circuits or physical components (this is used as an example in this specification), or may be integrated together. In other words, the clock control circuit 201 and the clock recovery circuit 202 may be an integrated component, for example, a clock and data recovery (carrier and data recovery, CDR) module.

The clock control circuit 201 may determine a sampling clock deviation of the data sampling circuit 203 based on a signal captured by the data sampling circuit 203, and feed back the sampling clock deviation to the clock recovery circuit 202. The clock recovery circuit 202 may adjust a sampling clock of the data sampling circuit 203 based on the sampling clock deviation fed back by the clock control circuit 201, and feed back an adjusted sampling clock to the data sampling circuit 203. The data sampling circuit 203 performs sampling based on the sampling clock fed back by the clock recovery circuit 202, and outputs a signal obtained through sampling to the clock control circuit 201. The sampling clock deviation of the data sampling circuit 203 can be reduced through adjustment by the clock recovery circuit 202. After the clock recovery circuit 202 performs one round of adjustment, if the sampling clock of the data sampling circuit 203 still deviates from an optimal sampling clock, the sampling clock of the data sampling circuit 203 may be adjusted again. For example, the data sampling circuit 203 may feed back, to the clock control circuit 201 again, a signal obtained through sampling based on the adjusted sampling clock. The clock control circuit 201 re-determines a sampling clock deviation of the data sampling circuit, generates a corresponding clock control signal, and feeds back the clock control signal to the clock recovery circuit 202. The clock recovery circuit 202 may adjust the sampling clock of the data sampling circuit 203 again based on the received clock control signal, and feed back, to the data sampling circuit 203, a clock signal obtained by an adjusted sampling clock. By analogy, the clock control circuit 201 and the clock recovery circuit 202 adjust the sampling clock of the data sampling circuit 203 for a plurality of times, until an actual sampling clock of the data sampling circuit 203 reaches the optimal sampling clock.

That the actual sampling clock of the data sampling circuit 203 reaches the optimal sampling clock may also be understood as that a sampling clock deviation of the data sampling circuit 203 is less than a first threshold. The first threshold may be preset or preconfigured. The first threshold is not limited in this embodiment of this application. For example, the first threshold may be a possible value obtained based on an experimental test. The first threshold may alternatively vary based on different sampling precision. For example, the first threshold may be a normalized clock deviation, for example, $10^{-6}$. It can be understood that, when the sampling clock deviation of the data sampling circuit 203 is less than the first threshold, a clock control signal generated by the clock control circuit is used to adjust the sampling clock of the data sampling circuit 203. When the sampling clock deviation of the data sampling circuit 203 is greater than or equal to the first threshold, the clock control circuit 201 may generate an indication signal, where the indication signal indicates that the sampling clock deviation of the data sampling circuit 203 is less than the first threshold. The clock recovery circuit 202 may determine, based on the indication signal fed back by the clock control circuit 201, that the sampling clock of the data sampling circuit 203 does not need to be further adjusted. In this case, the clock recovery circuit 202 directly outputs a final clock signal (referred to as a target clock signal in this specification) to the data sampling circuit 203 without adjusting the sampling clock of the data sampling circuit 203. The target clock signal may enable the sampling clock of the data sampling circuit 203 to reach an expected sampling clock.

For ease of understanding, an example in which the receiver receives a first analog signal from a transmitter is used below. The first analog signal is split into two signals, and the two signals are respectively referred to as an I signal and a Q signal. The I signal is a real component of the first analog signal, and the Q signal is an imaginary component of the first analog signal.

Still as shown in FIG. 2, the I signal and a local oscillator signal pass through a frequency mixer and a low-pass filter and are then input to the data sampling circuit 203. Similarly, the Q signal and the local oscillator signal pass through a frequency mixer and a low-pass filter and are then input to the data sampling circuit 203. The data sampling circuit 203 samples the I signal to obtain a first digital signal. The data sampling circuit 203 samples the Q signal to obtain a second digital signal. The data sampling circuit 203 outputs the first digital signal and the second digital signal to the clock control circuit 201. For example, the first digital signal $I'[k]$ and the second digital signal $Q'[k]$ respectively meet the following formulas:

$$I'[k] = \text{Re}\{(I_k + jQ_k) \times e^{-j2\pi\Delta fk\text{T}_s + \theta_o}\} \qquad (1)$$

$$Q'[k] = \text{Im}\{(I_k + jQ_k) \times e^{-j2\pi\Delta fk\text{T}_s + \theta_o}\} \qquad (2)$$

$I_k + jQ_k$ is a digital signal obtained by the data sampling circuit 203 by sampling the first analog signal, Ts is the sampling clock of the data sampling circuit 203, $\theta_o$ is a sampling phase deviation of the data sampling circuit 203, $\Delta f$ is a sampling frequency deviation of the data sampling circuit 203, and k is an index.

The clock control circuit 201 may determine a sampling clock deviation of the data sampling circuit 203 based on the first digital signal and the second digital signal, and based on the sampling clock deviation. For example, the clock control circuit 201 determines a first deviation signal between $I'[k]$ and $I_k$: error_s_I= $I'[k]$ - $\text{I}[k] = \frac{1}{m}\sum_{i=1}^{m}(I_i - \widehat{I}_i)^2$. For example, the clock control circuit 201 determines a second deviation signal between $Q'[k]$ and

$Q_k$: error_s_Q$=Q'[k] - Q[k]=\frac{1}{m}\sum_{i=1}^{m}(Q_i - \widehat{Q_i})^2$ . m is a preset integer.

After determining the first deviation signal and the second deviation signal, the clock control circuit 201 may determine the sampling clock deviation based on the first deviation signal and the second deviation signal: err_clock=-error_s_I+j×error_s_Q. Then a clock control signal err_clock is generated based on the sampling clock deviation. The clock control signal err_clock may be a linear function of a deviation signal err_clock. For example, error_s=k×(err_clock), where k is greater than 0. It can be understood that, when error_s is the smallest, err_clock is also the smallest. Therefore, a value and a direction of err_clock may be adjusted based on error_s.

It can be understood that, through a plurality of times of adjustment by the clock recovery circuit 202, the sampling clock deviation of the data sampling circuit 203 can be gradually reduced, in other words, error_s is gradually reduced. Correspondingly, an adjustment amount, indicated by a clock control signal, of the clock recovery circuit 202 for the sampling clock is also reduced. To be specific, through different times of adjustment, the clock recovery circuit 202 generates different clock control signals. For ease of description, a clock control signal determined by the clock control circuit 201 for the first time may be referred to as a first clock control signal. How the clock recovery circuit 202 adjusts the sampling clock of the data sampling circuit 203 based on a clock control signal fed back by the clock control circuit 201 is described below by using an example in which a clock control signal generated by the clock control circuit 201 is the first clock control signal.

In this embodiment of this application, the sampling clock of the data sampling circuit 203 can be locked at the optimal sampling clock. For example, the clock recovery circuit 202 processes a sampling clock for an analog signal input to the data sampling circuit 203, and determines, based on a processing result, whether the sampling clock of the data sampling circuit 203 is the optimal sampling clock. For example, the clock recovery circuit splits the input analog signal into two signals, and controls delay duration of the two signals to adjust the sampling clock of the data sampling circuit.

In a possible design, the clock recovery circuit 202 may include a signal splitter 2021, a first delayer 2022, a second delayer 2023, and a multiplication circuit 2024. The signal splitter 2021 is configured to split the first analog signal into a first analog sub-signal $r_{IF}(t)$ and a second analog sub-signal $r_{IF}(t)$. $r_{IF}(t)$ meets the following formula: $r_{IF}(t) = real(A(t)×exp(j×2×\pi×f0×t))$, where $A(t)$ is the first analog signal, $f0$ is a carrier frequency, t is time, *real* indicates to obtain a real part of a complex number, and exp is an exponential function. The first analog sub-signal $r_{IF}(t)$ is output to the first delayer 2022, and the second analog sub-signal $r_{IF}(t)$ is output to the second delayer 2023. The first clock control signal is separately fed back to input ends of the first delayer 2022 and the second delayer 2023. It should be noted that the signal splitter 2021 may alternatively be a power splitter, provided that one signal can be split into two signals. For example, the signal splitter 2021 may be a one-two power splitter.

The first delayer 2022 may delay the first analog sub-signal $r_{IF}(t)$ based on the first clock control signal, and the second delayer 2023 may delay the second analog sub-signal $r_{IF}(t)$ based on the first clock control signal. It is assumed that the first analog sub-signal $r_{IF}(t)$ is delayed by duration $\tau_1$, and the second analog sub-signal $r_{IF}(t)$ is delayed by duration $\tau_2$, a delayed first analog sub-signal $r_{IF}(t)$ is denoted as $r_{IF}(t-\tau_1)$, and a delayed second analog sub-signal $r_{IF}(t)$ is denoted as $r_{IF}(t-\tau_2)$. After $r_{IF}(t-\tau_1)$ and $r_{IF}(t-\tau_2)$ pass through the multiplication circuit 2024, a first signal is obtained: $S_1(t)=r_{IF}(t-\tau_1)× r_{IF}(t-\tau_2)$. After a high-frequency component is filtered out from the first signal $S_1(t)$ by using the low-pass filter, the following may be obtained:

$$S_2(t) = \mathrm{Re}\left\{\sum_{n=-\infty}^{+\infty} A_n \times e^{j\theta_n - 2j\pi f_{IF}(\tau_2-\tau_1)} \times g(t - nTs) \times g(t - nTs - T_s - \tau)\right\}$$

$$\approx \mathrm{Re}\{e^{-2j\pi f_{IF}^{T_s}} \times e^{-jED} \times \sum_{n=-\infty}^{+\infty} A_n \times e^{j\theta_n} \times g'(t - nTs)\}$$, where Ts is a sampling clock expected by the data sampling circuit 203, A in $A_n$ is an amplitude of a signal, n is a series, a value of n ranges from a quite small negative number to a quite large positive integer, the function g represents an integer function, the function *g'* represents an equivalent integer function, t represents time, $\tau$ represents $\pi$, and $f_{IF}$ represents a carrier frequency.

A power spectrum $S_2(f)$ of $S_2(t)$ meets the following formula:

$$S_2(f) = \mathrm{Re}\left\{Ae^{-jED}\sigma_A^2 \times \sum_{m=-\infty}^{+\infty}\frac{1}{Ts}G'\left(\frac{m}{Ts}\right) \times e^{j2\pi m/fTs}\right\}$$, where $ED = \frac{(\tau_2-\tau_1)-T_s}{T_s} \times 100\%$, $\sigma_A^2$ is noise power, G is a frequency domain expression of the function *g'*, and m is an integer.

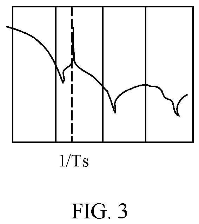

*Ts* is the optimal sampling clock of the data sampling circuit 203. FIG. 3 shows the power spectrum $S_2(f)$. A vertical coordinate in FIG. 3 is $S_2(f)$. It can be learned from FIG. 3 that, when $(\tau_2-\tau_1) = T_s$, $Ae^{-jED}\sigma_A^2$ reaches a maximum value. Therefore, when $\tau_2-\tau_1 = T_s$, it can be determined that the clock recovery circuit 202 has adjusted the sampling clock of the data sampling circuit 203 to the expected sampling clock. When $\tau_2-\tau_1 \neq T_s$, the sampling clock of the data sampling circuit 203 has not been adjusted to the expected sampling clock, and the clock recovery circuit 202 needs to continue to adjust the sampling clock of the data sampling circuit 203. To be specific, the clock recovery circuit 202 needs to continue to delay a received signal through the first delayer 2022 and the second delayer 2023.

It should be understood that delaying the received signal by the first delayer 2022 and the second delayer 2023 is actually shifting the received signal in time domain. In this embodiment of this application, the first delayer 2022 and the second delayer 2023 perform opposite shifts on the received signal in time domain. To be specific, when $\tau_1$ is a positive number, $\tau_2$ is a negative number, and when $\tau_1$ is a negative number, $\tau_2$ is a positive number. Through a plurality of times of adjustment by the clock recovery circuit 202, the sampling clock deviation of the data sampling circuit 203 can be gradually reduced, until the sampling clock of the data sampling circuit 203 is adjusted to the expected sampling clock. During a plurality of times of adjustment, the sampling clock deviation of the data sampling circuit 203 is gradually reduced. Therefore, duration by which the clock recovery circuit 202 delays a received signal through the first delayer 2022 should also be adaptively reduced. Similarly, duration by which the second delayer 2023 delays a received signal should also be adaptively reduced.

In a possible design, a plurality of delay steps may be separately predefined for the first delayer 2022 and the second delayer 2023. The clock recovery circuit 202 receives a clock control signal from the clock control circuit 201, and may select, based on a sampling clock deviation indicated by the clock control signal, a delay step matching the first delayer 2022 and a delay step matching the second delayer 2023. The first delayer 2022 is used as an example. A first delay step, a second delay step, and a third delay step may be predefined. The first delay step is greater than the second delay step, and the second delay step is greater than the third delay step. If a clock control signal received by the first delayer 2022 from the clock control circuit 201 indicates that a sampling clock deviation is greater than or equal to a first value, the first delayer 2022 delays the first analog sub-signal based on the first delay step $\tau_{11}$ to obtain a delayed signal, which is denoted as $r_{IF}(t-\tau_{11})$. If a clock control signal received by the first delayer 2022 from the clock control circuit 201 indicates that a sampling clock deviation is greater than or equal to a second value, the first delayer 2022 delays the first analog sub-signal based on the second delay step $\tau_{12}$ to obtain a delayed signal, which is denoted as $r_{IF}(t-\tau_{12})$. The first value is greater than the second value.

Similarly, for the second delayer 2023, a fourth delay step, a fifth delay step, and a sixth delay step may also be predefined. The fourth delay step is greater than the fifth delay step, and the fifth delay step is greater than the sixth delay step. If a clock control signal received by the second delayer 2023 from the clock control circuit 201 indicates that a sampling clock deviation is greater than or equal to a first value, the second delayer 2023 delays the first analog sub-signal based on the fourth delay step $\tau_{21}$ to obtain a delayed signal, which is denoted as $r_{IF}(t-\tau_{21})$. If a clock control signal received by the second delayer 2023 from the clock control circuit 201 indicates that a sampling clock deviation is greater than or equal to a second value, the second delayer 2023 delays the first analog sub-signal based on the fifth delay step $\tau_{22}$ to obtain a delayed signal, which is denoted as $r_{IF}(t-\tau_{22})$. It can be understood that the first delay step, the second delay step, and the third delay step are positive numbers, and the fourth delay step, the fifth delay step, and the sixth delay step are negative numbers, or the first delay step, the second delay step, and the third delay step are negative numbers, and the fourth delay step, the fifth delay step, and the sixth delay step are positive numbers. In this embodiment of this application, values of the first delay step, the second delay step, and the third delay step are not limited, and values of the fourth delay step, the fifth delay step, and the sixth delay step are not limited either.

It should be noted that some or all of the signal splitter 2021, the first delayer 2022, the second delayer 2023, and the multiplication circuit 2024 may be integrated together. For example, the first delayer 2022 and the second delayer 2023 may be integrated together as one component.

The first delayer 2022 and the second delayer 2023 feed back a generated signal to the clock control circuit 201, and the clock control circuit 201 determines whether the first delayer 2022 and the second delayer 2023 have adjusted a current sampling clock of the data sampling circuit 203 to the expected sampling clock. For ease of description, a signal generated by the first delayer 2022 is referred to as a first delayed signal, and a signal generated by the second delayer 2023 is referred to as a second delayed signal.

The clock control circuit 201 receives the first delayed signal from the first delayer 2022, receives the second delayed signal from the second delayer 2023, and determines whether the clock recovery circuit 202 has adjusted a current sampling clock of the data sampling circuit 203 to the expected sampling clock. For example, the clock control circuit 201 includes a decider 2012. The decider 2012 determines, based on the first delayed signal, first duration by which the first analog sub-signal is delayed, and determines, based on the second delayed signal, second duration by which the second analog sub-signal is delayed. If a deviation between the sampling clock Ts expected by the data sampling circuit 203 and a difference between the first duration and the second duration is greater than a first threshold, a first signal obtained by the multiplication circuit 2024 by multiplying the first delayed signal by the second delayed signal, namely, a clock signal generated by the clock recovery circuit 202, is not the target clock signal. In other words, the clock recovery circuit 202 is incapable of generating the target clock signal.

In this case, the clock control circuit 201 continues to calculate a sampling clock deviation based on an I signal and a Q signal that are received from the data sampling circuit 203, and generates a new clock control signal based on the sampling clock deviation. For example, the new clock control signal is referred to as a second clock control signal. For example, a processor 2011 in the clock control circuit 201 calculates a sampling clock deviation based on an I signal and a Q signal that are received from the data sampling circuit 203, and generates a second clock control signal based on the sampling clock deviation. The second clock control signal may indicate that a sampling clock deviation of the data sampling circuit 203 is less than a second threshold. The second clock control signal is fed back to the first delayer 2022 and the second delayer 2023. The first delayer 2022 and the second delayer 2023 separately delay a received signal based on the second clock control signal, and feed back a generated delayed signal to the clock control circuit 201 again, and so on, until the clock control circuit 201 determines that a deviation between the sampling clock Ts expected by the data sampling circuit 203 and a difference between delay duration corresponding to a first delayed signal and delay duration corresponding to a second delayed signal is less than or equal to the first threshold. In this case, the clock control circuit 201 feeds back an indication signal to the first delayer 2022 and the second delayer 2023, where the indication signal indicates that a sampling clock deviation of the data sampling circuit 203 is less than the first threshold. A first signal obtained by the multiplication circuit 2024 by multiplying the first delayed signal by the second delayed signal is the target clock signal. It should be understood that the indication signal is a special example of a clock control signal, and a specific implementation form of the indication signal is the same as that of the clock control signal. It can be understood that, if a sampling clock of the data sampling circuit 203 reaches the expected sampling clock through adjustment but an actual sampling clock of the data sampling circuit 203 deviates from the expected sampling clock during subsequent use, the sampling clock of the data sampling circuit 203 may be further adjusted by using the foregoing method, to make the actual sampling clock of the data sampling circuit 203 reach the expected sampling clock to a maximum extent.

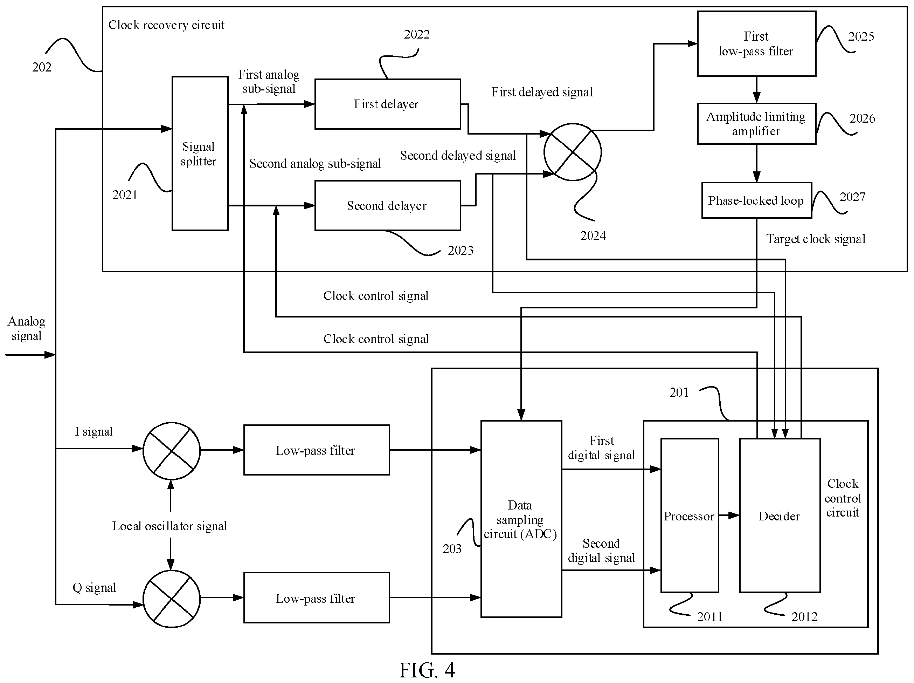

A high-frequency component included in the first signal output by the multiplication circuit 2024 may cause interference. Therefore, in a possible design, the clock recovery circuit 202 may further include a functional module for filtering out the high-frequency component from the first signal. For example, as shown in FIG. 4, in addition to the multiplication circuit 2024, the clock recovery circuit 202 may further include a low-pass filter 2025 connected to the multiplication circuit 2024. The low-pass filter 2025 may filter out the high-frequency component from the first signal, to reduce interference that may be caused by the first signal.

If an amplitude of the first signal is excessively large, the target clock signal may be inaccurate due to saturation. Therefore, the clock recovery circuit 202 may further include an amplitude limiting amplifier 2026 connected to the low-pass filter 2025. For example, the clock recovery circuit 202 may include the multiplication circuit 2024, the low-pass filter 2025, and the amplitude limiting amplifier 2026, as shown in FIG. 4. The amplitude limiting amplifier 2026 may filter out a component whose amplitude is greater than a preset amplitude from a signal output by the low-pass filter 2025, to reduce a probability that the first signal causes amplitude saturation.

If a frequency of a signal output by the amplitude limiting amplifier 2026 cannot be fixed, a sampling clock may be unable to converge, in other words, the sampling clock is unstable. Therefore, the clock recovery circuit 202 may further include a phase-locked loop 2027 connected to the amplitude limiting amplifier 2026. For example, the clock recovery circuit 202 may include the multiplication circuit 2024, the low-pass filter 2025, the amplitude limiting amplifier 2026, and the phase-locked loop 2027, as shown in FIG. 4. The phase-locked loop 2027 may enable a frequency of the target clock signal to be consistent with a frequency of the first signal output by the multiplication circuit 2024, to reduce a probability that a sampling clock is unstable due to phase instability.

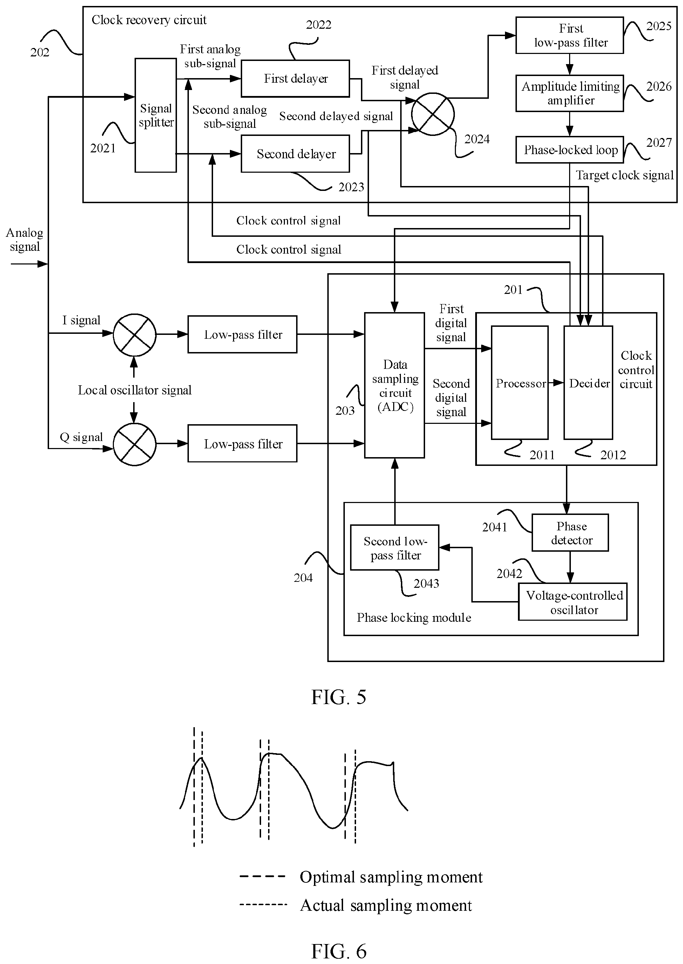

As shown in FIG. 5, the communication apparatus provided in this embodiment of this application may further include a phase locking module 204. For example, the communication apparatus includes the clock control circuit 201, the clock recovery circuit 202, the data sampling circuit 203, and the phase locking module 204. The clock control circuit 201 may be configured to eliminate a sampling phase deviation of the data sampling circuit 203. Specifically, the phase locking module 204 may include a phase detector 2041, a voltage-controlled oscillator 2042, and a low-pass filter 2043. An input end of the phase detector 2041 is connected to the clock control circuit 201. An output end of the phase detector 2041 is connected to an input end of the voltage-controlled oscillator 2042. An output end of the voltage-controlled oscillator 2042 is connected to an input end of the low-pass filter 2043. An output end of the low-pass filter 2043 is connected to the data sampling circuit.

The processor 2011 in the clock control circuit 201 may determine the sampling phase deviation of the data sampling circuit based on a first digital signal and a second digital signal that are received from the data sampling circuit 203. For ease of description, the first digital signal is denoted as I'(k), and the second digital signal is denoted as Q'(k). Assuming that there is no sampling phase deviation, a signal output by the digital sampling circuit 203 is $I_k + jQ_k$. The following is obtained:

$$I'(\mathrm{k}) = \mathrm{Re}\{(I_k + jQ_k) \times e^{-2j\pi\Delta f k \mathrm{Ts} + \theta_0}\};$$

and

$$Q'(\mathrm{k}) = \mathrm{Im}\{(I_k + jQ_k) \times e^{-2j\pi\Delta f k \mathrm{Ts} + \theta_0}\},$$

where

$\Delta f$ is a frequency deviation, and $\theta_0$ is the sampling phase deviation, to be specific, a deviation between an expected sampling clock and an actual sampling clock, as shown in FIG. 6.

The processor 2011 in the clock control circuit 201 may extract a deviation signal (error) between $I_k + jQ_k$ and I'(k) +Q'(k). It can be learned from the foregoing descriptions that $\text{error} = \frac{1}{m}\sum_{i=1}^{m}(I_i - \widehat{I_i})^2 + \frac{1}{m}\sum_{i=1}^{m}(Q_i - \widehat{Q_i})^2$. The processor 2011 feeds back the deviation signal to the phase detector 2041, and the voltage-controlled oscillator 2042 determines a sampling phase deviation. The voltage-controlled oscillator 2042 generates a third control signal based on the sampling phase deviation, the low-pass filter 2043 filters out a high-frequency component from the third control signal, and a signal obtained through filtering is output to the data sampling circuit 203. To reduce resource usage, the third control signal may indicate to increase or decrease a sampling phase, to ensure stability of a sampling phase of the data sampling circuit 203.

In the communication apparatus provided in this embodiment of this application, the sampling clock of the data sampling circuit 203 (namely, an ADC) can be locked at the expected sampling clock (the optimal sampling clock). Because the ADC is locked to operate at the optimal sampling clock, a digital signal obtained through sampling can retain wanted information of a raw analog signal without oversampling on the raw analog signal. Because a sampling frequency of the ADC is irrelevant to a value of bandwidth of the raw analog signal, analog signals at various types of bandwidth can be sampled. In addition, because the ADC does not need to oversample the raw analog signal, complexity of the ADC or complexity of a filter in the receiver is not increased even in a high-bandwidth scenario.

In embodiments provided in this application, the communication apparatus provided in embodiments of this application is described from a perspective of signal processing and transmission paths between circuits (or components or functional modules) included in the communication apparatus. Functional modules included in the communication apparatus may be hardware structures and/or software modules, and the foregoing functions are implemented in a form of a hardware structure, a software module, or a combination of a hardware structure and a software module. Whether a specific function of the foregoing functions is performed by a hardware structure, a software module, or a combination of a hardware structure and a software module depends on particular applications and design constraints of the technical solutions.

For example, circuits (or components or functional modules) included in the communication apparatus may be independent of each other, or may be integrated together, or may be coupled to each other. For example, the communication apparatus may be a chip system. In embodiments of this application, the chip system may include a chip, or may include a chip and another discrete component. For specific functions, refer to the descriptions in the foregoing embodiments.

For another example, the processor 2011 and the decider 2012 may be independent of each other, or may be coupled together. The processor 2011 and the decider 2012 that are coupled together may also be referred to as a processor. The processor may also be referred to as a processing unit or a processing module, and may implement a specific control function. The processor may be a general-purpose processor, a dedicated processor, or the like. For example, the processor includes a central processing unit, an application processor, a modem processor, a graphics processing unit, an image signal processor, a digital signal processor, a video codec processor, a controller, a memory, and/or a neural network processor. The central processing unit may be configured to control the communication apparatus, execute a software program, and/or process data. Different processors may be independent components, or may be integrated into one or more processors, for example, integrated into one or more application-specific integrated circuits.

The coupling in embodiments of this application may be an indirect coupling or a communication connection between apparatuses, units, or modules in an electrical form, a mechanical form, or another form, and is used for information exchange between the apparatuses, the units, or the modules. A plurality of modules that are coupled to each other may operate cooperatively.

It should be noted that the communication apparatus in the foregoing embodiments may alternatively be a circuit, or may be a chip used in a device, or another combined device or component that has a function of the foregoing communication apparatus, or the like.

An embodiment of this application further provides a receiver. The receiver includes the communication apparatus in the foregoing embodiment. The receiver further includes other necessary functional components, for example, a transceiver and an antenna. The transceiver may be referred to as a transceiver unit, a transceiver module, a transceiver device, a transceiver circuit, an input/output interface, or the like, and is configured to implement a transceiver function of the receiver through the antenna.

The communication apparatus described in this specification may be implemented as an independent device (for example, an independent integrated circuit or a mobile phone) or a part of a large device (for example, a module that may be embedded in another device). For details, refer to the foregoing descriptions about a terminal device and a network device. Details are not described herein again.

Optionally, the communication apparatus may further include one or more of the following components: a wireless communication module, an audio module, an external memory interface, an internal memory, a universal serial bus (universal serial bus, USB) interface, a power management module, an antenna, a speaker, a microphone, an input/output module, a sensor module, a motor, a camera, a display, or the like. It can be understood that, in some embodiments, the communication apparatus may include more or fewer components, or some components are integrated, or some components are split. The components may be implemented by hardware, software, or a combination of software and hardware.

Based on the same inventive concept, an embodiment of this application further provides a signal sampling method. The method is applied to a receiver. The receiver includes a communication apparatus. The communication apparatus includes a clock control circuit 201, a clock recovery circuit 202, and a data sampling circuit 203. The method includes: The clock control circuit 201 determines a sampling clock deviation of the data sampling circuit 203, and generates a first clock control signal based on the sampling clock deviation, where the first clock control signal is used to adjust a sampling clock of the data sampling circuit 203. The clock recovery circuit 202 adjusts the sampling clock of the data sampling circuit 203 based on the first clock control signal, and sends a clock signal to the data sampling circuit 203. The data sampling circuit 203 samples an input analog signal based on the clock signal.

In a possible implementation, the first clock control signal indicates that the sampling clock deviation of the data sampling circuit 203 is less than a first threshold, the clock signal is a target clock signal, and the target clock signal is capable of generating a sampling clock expected by the data sampling circuit 203.

In a possible implementation, the clock recovery circuit 202 includes a signal splitter 2021, a first delayer 2022, a second delayer 2023, and a multiplication circuit 2024. The first delayer 2022 is connected to the signal splitter 2021 and the clock control circuit 201, and the second delayer 2023 is connected to the signal splitter 2021 and the clock control circuit 201. The signal splitter 2021 splits an input analog signal into a first analog sub-signal and a second analog sub-signal. The first delayer 2022 delays the first analog sub-signal based on the first clock control signal to obtain a first delayed signal, and outputs the first delayed signal to the multiplication circuit 2024 and the clock control circuit 201. The second delayer 2023 delays the second analog sub-signal based on the first clock control signal to obtain a second delayed signal, and outputs the second delayed signal to the multiplication circuit 2024 and the clock control circuit 201. The multiplication circuit 2024 multiplies the first delayed signal by the second delayed signal to obtain a first signal, and outputs the first signal to the data sampling circuit 203.

In a possible implementation, the clock control circuit 201 includes a processor 2011 and a delayer 2012. The processor 2011 determines the sampling clock deviation based on a first digital signal and a second digital signal that are output by the data sampling circuit 203, and generates the first clock control signal based on the sampling clock deviation. The first digital signal is a real component obtained by the data sampling circuit 203 by sampling the input analog signal, and the second digital signal is an imaginary component obtained by the data sampling circuit 203 by sampling the input analog signal. The decider 2012 determines, based on the first delayed signal and the second delayed signal, that the clock recovery circuit 202 is incapable of generating the target clock signal, and outputs a second clock control signal to the clock recovery circuit 202.

In a possible implementation, the decider 2012 further determines, based on the first delayed signal and the second delayed signal, that the clock recovery circuit 202 is capable of generating the target clock signal, and outputs an indication signal to the clock recovery circuit 202. The indication information indicates that the sampling clock of the data sampling circuit 203 does not need to be adjusted.

In a possible implementation, the decider 2012 is specifically configured to: determine, based on the first delayed signal, first duration by which the first analog sub-signal is delayed; determine, based on the second delayed signal, second duration by which the second analog sub-signal is delayed; and when a deviation between the sampling clock expected by the data sampling circuit 203 and a difference between the first duration and the second duration is greater than the first threshold, determine that the clock recovery circuit 202 is incapable of generating the target clock signal.

In a possible implementation, the first delayer 2022 delays the first analog sub-signal based on a first delay step when the first clock control signal indicates that the sampling clock deviation is greater than or equal to a first value, or the first delayer 2022 delays the first analog sub-signal based on a second delay step when the first clock control signal indicates that the sampling clock deviation is less than the first value, where the first delay step is greater than the second delay step; and the second delayer 2023 delays the second analog sub-signal based on a third delay step when the first clock control signal indicates that the sampling clock deviation is greater than or equal to a first value, or the second delayer 2023 delays the second analog sub-signal based on a fourth delay step when the first clock control signal indicates that the sampling clock deviation is less than the first value, where the third delay step is greater than the fourth delay step.

In a possible implementation, the clock recovery circuit 202 further includes a first low-pass filter 2025 connected to the multiplication circuit 2024, and the first low-pass filter 2025 is configured to filter out a high-frequency component from the first signal.

In a possible implementation, the clock recovery circuit 202 further includes an amplitude limiting amplifier 2026 connected to the first low-pass filter 2025, and the amplitude limiting amplifier 2026 is configured to filter out a component whose amplitude is greater than a first amplitude from a signal output by the first low-pass filter 2025.

In a possible implementation, the clock recovery circuit 202 further includes a phase-locked loop 2027 connected to the amplitude limiting amplifier 2026, and the phase-locked loop 2027 is configured to enable a frequency of the target clock signal to be consistent with a frequency of the first signal.

In a possible implementation, the communication apparatus further includes a phase locking module 204, the phase locking module 204 is separately connected to the clock control circuit 201 and the data sampling circuit 203, and the method further includes: The phase locking circuit 204 determines a sampling phase deviation of the data sampling circuit 203 based on an error signal, generates a third control signal based on the sampling phase deviation, and outputs the third control signal to the data sampling circuit 203. The error signal is an error signal between the first digital signal and the second digital signal that are output by the data sampling circuit 203. The third control signal indicates the data sampling circuit 203 to adjust a sampling phase.

In a possible implementation, the phase locking module includes a phase detector 2041, a voltage-controlled oscillator 2042, and a second low-pass filter 2043 that are sequentially connected to the clock control circuit 201. An input end of the second low-pass filter 2043 is connected to the voltage-controlled oscillator 2042, and an output end of the second low-pass filter 2043 is connected to the data sampling circuit 203.

An embodiment of this application further provides a communication system. Specifically, the communication system includes the communication apparatus and the sending apparatus in any one of FIG. 2 to FIG. 5. For details, refer to related descriptions in the foregoing method embodiments. Details are not described herein again.

An embodiment of this application further provides a computer-readable storage medium, including instructions. When the instructions are run on a computer, the computer is enabled to implement the functions of the communication apparatus in any one of FIG. 2 to FIG. 5.

An embodiment of this application further provides a computer program product, including instructions. When the instructions are run on a computer, the computer is enabled to implement the functions of the communication apparatus in any one of FIG. 2 to FIG. 5.

An embodiment of this application provides a chip system. The chip system includes a processor, and may further include a memory, so that a device on which the chip system is installed implements the functions of the communication apparatus in any one of FIG. 2 to FIG. 5. The chip system may include a chip, or may include a chip and another discrete component.

It should be understood that sequence numbers of the foregoing processes do not mean execution sequences in embodiments of this application. The execution sequences of the processes should be determined based on functions and internal logic of the processes, and should not be construed as any limitation on implementation processes of embodiments of this application.

A person of ordinary skill in the art may be aware that various illustrative logical blocks (illustrative logical block) and steps (step) described with reference to embodiments disclosed in this specification can be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

It can be clearly understood by a person skilled in the art that, for ease and brevity of description, for detailed working processes of the foregoing system, apparatus, and unit, reference may be made to corresponding processes in the foregoing method embodiments. Details are not described herein again.

In several embodiments provided in this application, it should be understood that the disclosed system, apparatus, and method may be implemented in other manners. For example, the described apparatus embodiments are merely examples. For example, division into the units is merely logical function division and may be other division during actual implementation. For example, a plurality of units or components may be combined or integrated into another system, or some features may be ignored or not performed. In addition, the shown or discussed mutual couplings or direct couplings or communication connections may be implemented through some interfaces. The indirect couplings or communication connections between the apparatuses or units may be implemented in electrical, mechanical, or other forms.

The units described as separate components may or may not be physically separate, and components shown as units may or may not be physical units, to be specific, may be located in one place, or may be distributed on a plurality of network units. Some or all of the units may be selected according to actual requirements to achieve objectives of solutions of embodiments.

When the functions are implemented in a form of a software functional unit and sold or used as an independent product, the functions may be stored in a computer-readable storage medium. Based on such an understanding, the essentially contributing part of the technical solutions of this application or some of the technical solutions may be implemented in a form of a software product. The computer software product is stored in a storage medium and includes several instructions for instructing a computer device (which may be a personal computer, a server, a network device, or the like) to perform all or some of the steps of the methods described in embodiments of this application. The storage medium includes any medium that can store program code, for example, a USB flash drive, a removable hard disk, a read only memory (read-only memory, ROM), a random access memory (random access memory, RAM), a magnetic disk, or a compact disc.

It should be noted that a connection in this application describes a connection relationship between two objects, and may represent two connection relationships. For example, a connection between A and B may represent two cases: A is directly connected to B, and A is connected to B through C. In addition, it should be understood that, in descriptions of this application, the terms "first", "second", and the like are merely used for distinguishing and description, but should not be understood as indicating or implying relative importance, and should not be understood as indicating or implying a sequence either. In addition, the system structure and the service scenario provided in embodiments of this application are mainly intended to explain some possible implementations of the technical solutions of this application, and should not be construed as a unique limitation on the technical solutions of this application. A person of ordinary skill in the art may know that, with evolution of a system and emergence of an updated service scenario, the technical solutions provided in this application are also applicable to a same or similar technical problem.

Clearly, a person skilled in the art can make various modifications and variations to this application without departing from the scope of this application. This application is intended to cover these modifications and variations of this application provided that they fall within the scope of the claims of this application and equivalent technologies thereof.

## Claims

1. A communication apparatus, comprising a clock control circuit, a data sampling circuit, and a clock recovery circuit, wherein

the clock control circuit is configured to determine a sampling clock deviation of the data sampling circuit, and generate a first clock control signal based on the sampling clock deviation, wherein the first clock control signal is used to adjust a sampling clock of the data sampling circuit;
the clock recovery circuit is configured to adjust the sampling clock of the data sampling circuit based on the first clock control signal, and send a clock signal to the data sampling circuit; and
the data sampling circuit is configured to sample an input analog signal based on the clock signal.

2. The apparatus according to claim 1, wherein when the first clock control signal indicates that the sampling clock deviation of the data sampling circuit is less than a first threshold, the clock signal is a target clock signal, and the target clock signal is capable of generating a sampling clock expected by the data sampling circuit.

3. The apparatus according to claim 1 or 2, wherein the clock recovery circuit comprises:

a signal splitter, configured to split an input analog signal into a first analog sub-signal and a second analog sub-signal;
a first delayer, connected to the signal splitter and the clock control circuit, and configured to delay the first analog sub-signal based on the first clock control signal to obtain a first delayed signal, and output the first delayed signal to a multiplication circuit and the clock control circuit;
a second delayer, connected to the signal splitter and the clock control circuit, and configured to delay the second analog sub-signal based on the first clock control signal to obtain a second delayed signal, and output the second delayed signal to the multiplication circuit and the clock control circuit; and
the multiplication circuit, configured to multiply the first delayed signal by the second delayed signal to obtain a first signal, and output the first signal to the data sampling circuit.

4. The apparatus according to claim 2 or 3, wherein the clock control circuit comprises:

a processor, configured to determine the sampling clock deviation based on a first digital signal and a second digital signal that are output by the data sampling circuit, and generate the first clock control signal based on the sampling clock deviation, wherein the first digital signal is a real component obtained by the data sampling circuit by sampling the input analog signal, and the second digital signal is an imaginary component obtained by the data sampling circuit by sampling the analog signal; and
a decider, configured to determine, based on the first delayed signal and the second delayed signal, that the clock recovery circuit is incapable of generating the target clock signal, and output a second clock control signal to the clock recovery circuit.

**5.** The apparatus according to claim 4, wherein the decider is further configured to:
determine, based on the first delayed signal and the second delayed signal, that the clock recovery circuit is capable of generating the target clock signal, and output an indication signal to the clock recovery circuit, wherein the indication information indicates that the sampling clock of the data sampling circuit does not need to be adjusted.

**6.** The apparatus according to claim 4, wherein the decider is specifically configured to:

determine, based on the first delayed signal, first duration by which the first analog sub-signal is delayed;
determine, based on the second delayed signal, second duration by which the second analog sub-signal is delayed; and
when a deviation between the sampling clock expected by the data sampling circuit and a difference between the first duration and the second duration is greater than the first threshold, determine that the clock recovery circuit is incapable of generating the target clock signal.

**7.** The apparatus according to claim 3, wherein that the first delayer delays the first analog sub-signal based on the first clock control signal comprises:

the first delayer delays the first analog sub-signal based on a first delay step when the first clock control signal indicates that the sampling clock deviation is greater than or equal to a first value, or the first delayer delays the first analog sub-signal based on a second delay step when the first clock control signal indicates that the sampling clock deviation is less than the first value, wherein the first delay step is greater than the second delay step; and
that the second delayer delays the second analog sub-signal based on the first clock control signal comprises:
the second delayer delays the second analog sub-signal based on a third delay step when the first clock control signal indicates that the sampling clock deviation is greater than or equal to a first value, or the second delayer delays the second analog sub-signal based on a fourth delay step when the first clock control signal indicates that the sampling clock deviation is less than the first value, wherein the third delay step is greater than the fourth delay step.

**8.** The apparatus according to any one of claims 2 to 7, wherein the clock recovery circuit further comprises:
a first low-pass filter, connected to the multiplication circuit, and configured to filter out a high-frequency component from the first signal.

**9.** The apparatus according to claim 8, wherein the clock recovery circuit further comprises:
an amplitude limiting amplifier, connected to the first low-pass filter, and configured to filter out a component whose amplitude is greater than a first amplitude from a signal output by the first low-pass filter.

**10.** The apparatus according to claim 9, wherein the clock recovery circuit further comprises:
a phase-locked loop, connected to the amplitude limiting amplifier, and configured to enable a frequency of the target clock signal to be consistent with a frequency of the first signal.

**11.** The apparatus according to any one of claims 1 to 10, wherein the apparatus further comprises a phase locking module, the phase locking module is separately connected to the clock control circuit and the data sampling circuit, and the phase locking circuit is configured to:

determine a sampling phase deviation of the data sampling circuit based on an error signal, and generate a third control signal based on the sampling phase deviation, wherein the error signal is an error signal between the first digital signal and the second digital signal that are output by the data sampling circuit; and
output the third control signal to the data sampling circuit, wherein the third control signal indicates the data sampling circuit to adjust a sampling phase.

**12.** The apparatus according to claim 11, wherein the phase locking module comprises:

a phase detector, connected to the clock control circuit;
a voltage-controlled oscillator, connected to the phase detector; and
a second low-pass filter, wherein an input end of the second low-pass filter is connected to the voltage-controlled oscillator, and an output end of the second low-pass filter is connected to the data sampling circuit.

**13.** A signal sampling method, applied to a communication apparatus, wherein the communication apparatus comprises a clock control circuit, a data sampling circuit, and a clock recovery circuit, wherein

the clock control circuit determines a sampling clock deviation of the data sampling circuit, and generates a first clock control signal based on the sampling clock deviation, wherein the first clock control signal is used to adjust a sampling clock of the data sampling circuit;

the clock recovery circuit adjusts the sampling clock of the data sampling circuit based on the first clock control signal, and sends a clock signal to the data sampling circuit; and

the data sampling circuit samples an input analog signal based on the clock signal.

14. The method according to claim 13, wherein when the first clock control signal indicates that the sampling clock deviation of the data sampling circuit is less than a first threshold, the clock signal is a target clock signal, and the target clock signal is capable of generating a sampling clock expected by the data sampling circuit.

15. The method according to claim 13 or 14, wherein the clock recovery circuit comprises a signal splitter, a first delayer, a second delayer, and a multiplication circuit, the first delayer is connected to the signal splitter and the clock control circuit, and the second delayer is connected to the signal splitter and the clock control circuit, wherein

the signal splitter splits an input analog signal into a first analog sub-signal and a second analog sub-signal;

the first delayer delays the first analog sub-signal based on the first clock control signal to obtain a first delayed signal, and outputs the first delayed signal to the multiplication circuit and the clock control circuit;

the second delayer delays the second analog sub-signal based on the first clock control signal to obtain a second delayed signal, and outputs the second delayed signal to the multiplication circuit and the clock control circuit; and

the multiplication circuit multiplies the first delayed signal by the second delayed signal to obtain a first signal, and outputs the first signal to the data sampling circuit.

16. The method according to claim 14 or 15, wherein the clock control circuit comprises a processor and a delayer, wherein the processor determines the sampling clock deviation based on a first digital signal and a second digital signal that are output by the data sampling circuit, and generates the first clock control signal based on the sampling clock deviation, wherein the first digital signal is a real component obtained by the data sampling circuit by sampling the input analog signal, and the second digital signal is an imaginary component obtained by the data sampling circuit by sampling the analog signal; and

the decider determines, based on the first delayed signal and the second delayed signal, that the clock recovery circuit is incapable of generating the target clock signal, and outputs a second clock control signal to the clock recovery circuit.

17. The method according to claim 16, wherein the decider further determines, based on the first delayed signal and the second delayed signal, that the clock recovery circuit is capable of generating the target clock signal, and outputs an indication signal to the clock recovery circuit, wherein the indication information indicates that the sampling clock of the data sampling circuit does not need to be adjusted.

18. The method according to claim 16, wherein the decider is specifically configured to:

determine, based on the first delayed signal, first duration by which the first analog sub-signal is delayed;

determine, based on the second delayed signal, second duration by which the second analog sub-signal is delayed; and

when a deviation between the sampling clock expected by the data sampling circuit and a difference between the first duration and the second duration is greater than the first threshold, determine that the clock recovery circuit is incapable of generating the target clock signal.

19. The method according to claim 15, wherein the first delayer delays the first analog sub-signal based on a first delay step when the first clock control signal indicates that the sampling clock deviation is greater than or equal to a first value, or the first delayer delays the first analog sub-signal based on a second delay step when the first clock control signal indicates that the sampling clock deviation is less than the first value, wherein the first delay step is greater than the second delay step; and

the second delayer delays the second analog sub-signal based on a third delay step when the first clock control signal indicates that the sampling clock deviation is greater than or equal to a first value, or the second delayer delays the second analog sub-signal based on a fourth delay step when the first clock control signal indicates that the sampling clock deviation is less than the first value, wherein the third delay step is greater than the fourth delay step.

20. The method according to any one of claims 14 to 19, wherein the clock recovery circuit further comprises a first low-pass filter connected to the multiplication circuit, and the first low-pass filter is configured to filter out a high-frequency component from the first signal.

21. The method according to claim 20, wherein the clock recovery circuit further comprises an amplitude limiting amplifier connected to the first low-pass filter, and the amplitude limiting amplifier is configured to filter out a component whose amplitude is greater than a first amplitude from a signal output by the first low-pass filter.

22. The method according to claim 21, wherein the clock recovery circuit further comprises a phase-locked loop connected to the amplitude limiting amplifier, and the phase-locked loop is configured to enable a frequency of the target clock signal to be consistent with a frequency of the first signal.

23. The method according to any one of claims 13 to 22, wherein the communication apparatus further comprises a phase locking module, the phase locking module is separately connected to the clock control circuit and the data sampling circuit, and the method further comprises:
determining, by the phase locking circuit, a sampling phase deviation of the data sampling circuit based on an error signal, generating a third control signal based on the sampling phase deviation, and outputting the third control signal to the data sampling circuit, wherein the error signal is an error signal between the first digital signal and the second digital signal that are output by the data sampling circuit, and the third control signal indicates the data sampling circuit to adjust a sampling phase.

24. The method according to claim 23, wherein the phase locking module comprises:

    a phase detector, connected to the clock control circuit;
    a voltage-controlled oscillator, connected to the phase detector; and
    a second low-pass filter, wherein an input end of the second low-pass filter is connected to the voltage-controlled oscillator, and an output end of the second low-pass filter is connected to the data sampling circuit.

25. A chip system, comprising:

    a communication interface, configured to input and/or output information; and
    a processor, configured to execute a computer program, to enable a device on which the chip system is installed to perform the method according to any one of claims 13 to 24.

26. A computer-readable storage medium, wherein the storage medium stores a computer program or instructions, and when the computer program or instructions are executed, the method according to any one of claims 13 to 24 is implemented.

27. A transmitter, comprising the communication apparatus according to any one of claims 1 to 12.

28. A base station, comprising the communication apparatus according to any one of claims 1 to 12.

Transmitter

Raw signal

Baseband chip → Digital-to-analog converter

Radio frequency chip → Power amplifier

Wired cable

Receiver

Radio frequency chip → Analog-to-digital converter

Sampling clock synchronization

Baseband processing chip

Raw signal

FIG. 1

FIG. 2

1/Ts

FIG. 3

FIG. 4

FIG. 5

- - - - Optimal sampling moment

------- Actual sampling moment

FIG. 6

## INTERNATIONAL SEARCH REPORT

| International application No. |
|---|
| **PCT/CN2022/116603** |

### A. CLASSIFICATION OF SUBJECT MATTER

H04L7/00(2006.01)i;H04L7/033(2006.01)i;H04L27/00(2006.01)i;H04J3/06(2006.01)i

According to International Patent Classification (IPC) or to both national classification and IPC

### B. FIELDS SEARCHED

Minimum documentation searched (classification system followed by classification symbols)

IPC:H04L7/-; H04L27/-; H04J3/-

Documentation searched other than minimum documentation to the extent that such documents are included in the fields searched

Electronic data base consulted during the international search (name of data base and, where practicable, search terms used)

CNTXT; CNABS; CNKI; 百度, BAIDU: 同步, 时钟, 模拟数字转换, 采样, 偏差, 误差, 相位, 频率, 延迟, 反馈, 控制, 调整; VEN; USTXT; EPTXT; WOTXT; IEEE; 3GPP: synchronization, clock, ADC, sampling, error, bias, offset, phase, frequency, delay, feedback, control, adjust+

### C. DOCUMENTS CONSIDERED TO BE RELEVANT

| Category* | Citation of document, with indication, where appropriate, of the relevant passages | Relevant to claim No. |
|---|---|---|
| Y | CN 102164031 A (HUAWEI TECHNOLOGIES CO., LTD.) 24 August 2011 (2011-08-24) description, paragraphs [0041]-[0076], and figures 4-6 | 1-28 |
| Y | CN 112118063 A (HUAWEI TECHNOLOGIES CO., LTD.) 22 December 2020 (2020-12-22) description, paragraphs [0041]-[0059] | 1-28 |
| A | CN 101610083 A (ZTE CORP.) 23 December 2009 (2009-12-23) description, pages 5-7 | 1-28 |
| A | US 2018323956 A1 (GLOBAL UNICHIP CORP. et al.) 08 November 2018 (2018-11-08) description, paragraphs [0014]-[0040] | 1-28 |
| A | US 5673295 A (SYNOPSYS INC.) 30 September 1997 (1997-09-30) description, column 2 line 60-column 5 line 8 | 1-28 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **17 May 2023** | **23 May 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2022/116603**

| Patent document cited in search report | | | Publication date (day/month/year) | Patent family member(s) | | | Publication date (day/month/year) |
|---|---|---|---|---|---|---|---|
| CN | 102164031 | A | 24 August 2011 | CN | 102164031 | B | 21 May 2014 |
| CN | 112118063 | A | 22 December 2020 | WO | 2020253687 | A1 | 24 December 2020 |
| | | | | EP | 3975456 | A1 | 30 March 2022 |
| | | | | EP | 3975456 | A4 | 03 August 2022 |
| | | | | US | 2022116115 | A1 | 14 April 2022 |
| | | | | CN | 112118063 | B | 24 May 2022 |
| CN | 101610083 | A | 23 December 2009 | CN | 101610083 | B | 10 October 2012 |
| US | 2018323956 | A1 | 08 November 2018 | TWI | 635710 | B | 11 September 2018 |
| | | | | TW | 201843936 | A | 16 December 2018 |
| | | | | US | 10439793 | B2 | 08 October 2019 |
| | | | | CN | 108809304 | A | 13 November 2018 |
| | | | | CN | 108809304 | B | 21 January 2022 |
| US | 5673295 | A | 30 September 1997 | | None | | |

Form PCT/ISA/210 (patent family annex) (July 2022)